# EUROPÄISCHE PATENTSCHRIFT

(11) **EP 3 934 391 B1**
(45) Veröffentlichungstag und Bekanntmachung des Hinweises auf die Patenterteilung: **14.02.2024**
(21) Anmeldenummer: 20184034.5
(22) Anmeldetag: 03.07.2020
(51) Int. Cl.: H05K 3/00

(54) **VERFAHREN ZUM ZUMINDEST TEILWEISEN VERSCHLIESSEN EINER KANALFÖRMIGEN ÖFFNUNG**
METHOD FOR AT LEAST PARTIALLY CLOSING A CHANNEL-SHAPED OPENING
PROCÉDÉ DE FERMETURE AU MOINS PARTIELLE D'UNE OUVERTURE EN FORME DE CANAL

(43) Veröffentlichungstag der Anmeldung: 05.01.2022
(73) Patentinhaber: Peters Research GmbH & Co. Kommanditgesellschaft, 47906 Kempen (DE)
(72) Erfinder: Schwartz, Ralf, 47800 Krefeld (DE); Müller, Michael, 46049 Oberhausen (DE); Tekath, Johannes, 48653 Coesfeld (DE)
(74) Vertreter: Dr. Stark & Partner Patentanwälte mbB

(56) Entgegenhaltungen:
- WO-A2-02/091811
- DE-A1-102014 106 636
- US-A1- 2017 265 311
- CRUM S: "HOLE PLUGGING WITH LIQUID PHOTOIMAGEABLE SOLDER MASKS", ELECTRONIC PACKAGING AND PRODUCTION, CAHNERS PUBLISHING CO, NEWTON, MASSACHUSETTS, US, Bd. 37, Nr. 4, 1. März 1997 (1997-03-01), XP000687295, ISSN: 0013-4945

## Beschreibung

Die Erfindung betrifft ein Verfahren zum zumindest teilweisen Verschließen einer kanalförmigen Öffnung mit einer Querschnittsfläche und einer Durchgangslänge, insbesondere Durchgangs-Bohrungen oder Durchkontaktierungen in Leiterplatten, mit einem flüssigen härtbaren bzw. aushärtenden Verfüllmaterial.

Aus der Praxis sind verschiedenste Verfahren bekannt, um kanalförmige Öffnungen zu verschließen. Jedoch können viele Verfahren nicht in allen technischen Bereichen eingesetzt werden oder aber es ist ein Einsatz in manchen Bereichen mit Nachteilen verbunden.

So ist zum Beispiel das Verschließen von Durchgangs-Bohrungen oder Durchkontaktierungen in Leiterplatten mit besonderen Anforderungen verbunden. Denn bei der Herstellung von Leiterplatten werden verschiedenste Lacke eingesetzt, die Ätzresiste zur Strukturierung des Leiterbildes, Lötstopplacke, Kennzeichnungsdrucke, Durchsteigerfüller und weitere funktionelle Lackschichten umfassen können. Diese Lacke werden üblicherweise selektiv und durch ein Siebdruckverfahren aufgebracht. Bei Lötstopplacken werden auch fotolithographische Prozesse genutzt, da hierdurch feinere Strukturen dargestellt werden können.

Da für den Siebdruck eine dem Drucklayout entsprechende Siebschablone angefertigt werden muss und für die fotolithographisch strukturierbaren Lacke entsprechende Belichtungsfilme notwendig sind, sind Abweichungen wie z. B. Layoutänderungen oder Kleinserien entsprechend zeitaufwendig und teuer. Alternativ kann die Belichtung auch direkt mittels Laserstrukturierung erfolgen. Nach der Belichtung ist dann ein Entwicklungsprozess notwendig, durch den die nicht belichteten Lackbereiche mittels entsprechender Entwicklermedien abgelöst werden.

Hingegen können mittels digital gesteuerter Applikationsprozesse die gewünschten Beschichtungen auch direkt selektiv aufgebracht werden, wodurch viele Prozessschritte und somit sowohl Zeit als auch Material eingespart werden können. Diese sind daher für Kleinserien bis zur Losgröße 1 und einfache Layout-Wechsel prädestiniert.

In der Praxis werden bereits einige der Fertigungsprozesse mit digital gesteuerten Applikationsprozessen durchgeführt, wobei der Inkjet-Druck ein besonders bevorzugtes Beschichtungsverfahren ist.

Bei Leiterplatten mit komplexeren Strukturen sind häufig mehr als eine Ebene mit Leiterstrukturen vorgesehen. Diese sogenannten Multilayer benötigen dabei leitfähige Verbindungen zwischen den einzelnen Ebenen, die üblicherweise durch Durchkontaktierungen realisiert werden. Hierbei handelt es sich um in die Leiterplatte eingebrachte Durchgangsbohrungen bzw. Löcher, wobei der elektrisch leitfähige Kontakt beispielsweise durch eine Metallisierung der Bohrlochwandung hergestellt wird.

Allerdings kann in der Praxis die Notwendigkeit bestehen, die Durchgangsbohrungen anschließend wieder zu verschließen. Die kann beispielsweise aufgrund des sogenannten In-Circuit-Tests sein, bei dem die Leiterplatte auf ihre elektrische Funktion hin getestet wird und hierfür per Vakuumadaption auf einem bestimmten Träger fixiert werden muss. Dies ist jedoch nicht möglich, wenn Durchgangsbohrungen verhindern, dass ein Vakuum über die gesamte Leiterplattenfläche wirken kann.

Es kann zudem notwendig sein, die Leiterplatte nach ihrer Bestückung mit Bauteilen mit einem zusätzlichen Schutzlack zu versehen. Diese in der Regel dünnflüssigen Schutzlacke können jedoch durch die Durchgangsbohrungen auf die gegenüberliegende Leiterplattenseite abfließen, fehlen somit zum einen auf der Beschichtungsseite und können auch in Bereiche fließen, die nicht lackiert werden sollen oder sogar dürfen.

Außerdem können sich in nicht gefüllten, also (noch) offenen Durchgangsbohrungen Chemikalien aus nasschemischen Prozessen, die zur Veredelung der Kupferoberflächen eingesetzt werden, ansammeln und dort zurückbleiben, die später dann an dieser Stelle zu Korrosionseffekten führen und somit beispielsweise die Durchkontaktierung schwächen oder sogar zerstören.

Außerdem kann es notwendig oder aber zumindest vorteilhaft sein, die Durchgangsbohrungen funktionell mit einem entsprechend ausgebildeten Verfüllmaterial zu füllen. Dies kann eine komplette Verfüllung mit elektrisch und/oder thermisch leitfähigen, magnetisierbaren, dielektrischen oder besonders ausdehnungsarmen Materialien sein.

WO 02/091811 A2 offenbart ein Verfahren zum Verschließen von Durchgangsöffnungen gemäß dem Oberbegriff des Anspruchs 1.

Aufgabe der Erfindung ist es, die vorgenannten Nachteile zu vermeiden und Verfahren zum zumindest teilweisen Verschließen einer kanalförmigen Öffnung mit einer Querschnittsfläche und einer Durchgangslänge anzugeben, mit dem in einfacher Weise das teilweise Verschließen der kanalförmigen Öffnung möglich ist.

Diese Aufgabe wird bei einem gattungsgemäßen Verfahren dadurch gelöst, dass das Verschließen der Öffnung mittels eines digital gesteuerten Applikationsverfahrens mit zwei gegenüberliegend angeordneten Ausgabeköpfen erfolgt, vorzugsweise mit einem Inkjet-Verfahren mit zwei gegenüberliegend angeordneten, als Druckköpfe ausgebildeten Ausgabeköpfen erfolgt, wobei die beiden Ausgabeköpfe so angesteuert werden, dass die Öffnung von beiden Seiten durch die beiden Enden gleichzeitig mit dem Verfüllmaterial verfüllt wird und das Verfüllmaterial von den beiden Ausgabeköpfen unter Berücksichtigung der jeweiligen Leistungsdaten der beiden Ausgabeköpfe und des jeweiligen Abstands der beiden Ausgabeköpfe zu der Öffnung so ausgegeben wird, dass sich die ausgegebenen Mengen des Verfüllmaterials innerhalb der Öffnung treffen.

Dabei hat die Querschnittsfläche der Öffnung in keiner Richtung eine Erstreckung, die größer ist als 3 mm bis 5 mm. Die Querschnittsfläche der Öffnung kann kreisrund sein, was beispielsweise bei Bohrungen der Fall ist.

Somit fliegt das von den Ausgabeköpfen in die Öffnung injizierte Verfüllmaterials nicht durch die Öffnung durch, sondern trifft auf das aus der anderen Richtung kommende Verfüllmaterial, wodurch dann das Verfüllmaterial zur Seite weg spritzt und sich an der Wandung der Öffnung anlagert.

Das Verfüllmaterial wird dabei mit einer Geschwindigkeit von 5 m/s bis 10 m/s aus den Ausgabeköpfen ausgegeben. Dies erfolgt intermittierend, so dass Tropfen ausgegeben werden. Das Volumen der Tropfen beträgt 1 pl (Picoliter) bis 20 pl, vorzugsweise 3 pl bis 10 pl. Die Frequenz der Tropfenausgabe kann dabei 5 kHz bis 10 kHz betragen. Bei einer intermittierenden Ausgabe des Verfüllmaterials kann das Härten beispielsweise ebenfalls intermittierend in den Zeitbereichen erfolgen, wenn keine Ausgabe des Verfüllmaterials erfolgt. Ein solch getaktetes Härten kann bei geeignetem Verfüllmaterial beispielsweise mittels eine Stroboskops erfolgen.

Dabei können erfindungsgemäß die beiden Ausgabeköpfe so angesteuert werden, dass das Verfüllmaterial von den beiden Ausgabeköpfen unter Berücksichtigung der jeweiligen Leistungsdaten der beiden Ausgabeköpfe und des jeweiligen Abstands der beiden Ausgabeköpfe zu der Öffnung so ausgegeben wird, dass sich die ausgegebenen Mengen des Verfüllmaterials zumindest in etwa im Bereich der Mitte der Durchgangslänge der Öffnung treffen. Dies ist vor allem bei einer kompletten Auffüllung von Vorteil, da sich dann zuerst eine in der Mitte der Durchgangslänge der Öffnung angeordnete Trennwandung bildet und die beiden dadurch resultierenden Sacklöcher dann jeweils durch den zugeordneten Ausgabekopf weiter gefüllt werden können.

Alternativ kann die Ausgabe des Verfüllmaterials durch die Ausgabeköpfe auch derart erfolgen, dass sich die ausgegebenen Mengen des Verfüllmaterials in etwa im Bereich eines Endes der Öffnung treffen. Somit kann die Öffnung einseitig zumindest in etwa bündig geschlossen werden, wohingegen sie von der anderen Seite aus aufbleiben und ungefüllt verbleiben kann.

Auch können die beiden Ausgabeköpfe so angesteuert werden, dass das Verfüllmaterial von den beiden Ausgabeköpfen unter Berücksichtigung der jeweiligen Leistungsdaten der beiden Ausgabeköpfe und des jeweiligen Abstands der beiden Ausgabeköpfe zu der Öffnung so ausgegeben wird, dass sich die ausgegebenen Mengen des Verfüllmaterials zumindest in etwa im Bereich der Mitte der Querschnittsfläche der Öffnung treffen, so dass bei einer geeigneten Dimensionierung der Querschnittsfläche der Öffnung das eingebrachte Material dann gleichmäßig an die Wandung der Öffnung spritzt.

Alternativ kann die Ausgabe des Verfüllmaterials durch die Ausgabeköpfe auch derart erfolgen, dass sich die ausgegebenen Mengen des Verfüllmaterials in etwa im Bereich der Wandung der Öffnung treffen. Somit kann die Öffnung von einem Wandungsbereich ausgehend zumindest teilweise geschlossen werden, wenn beispielsweise die Querschnittsfläche zu groß ist, als dass die Öffnung in einem Schritt geschlossen werden kann.

Vorzugsweise können die beiden Ausgabeköpfe so angesteuert werden, dass das Verfüllmaterial von den beiden Ausgabeköpfen unter Berücksichtigung der jeweiligen Leistungsdaten der beiden Ausgabeköpfe und des jeweiligen Abstands der beiden Ausgabeköpfe zu der Öffnung so ausgegeben wird, dass die Querschnittsfläche der Öffnung vollständig verschlossen wird. Damit ist der Durchgang durch die Öffnung dann blockiert.

Erfindungsgemäß können die beiden Ausgabeköpfe auch so angesteuert werden, dass das Verfüllmaterial von den beiden Ausgabeköpfen unter Berücksichtigung der jeweiligen Leistungsdaten der beiden Ausgabeköpfe und des jeweiligen Abstands der beiden Ausgabeköpfe zu der Öffnung so ausgegeben wird, dass die Öffnung vollständig verschlossen wird. Somit wird die Öffnung beidseits zumindest in etwa jeweils bündig geschlossen. Es verbleibt keine Kavität, in der sich unerwünschte Ansammlungen von Rückständen anderer Stoffe bilden können.

Vorteilhafterweise kann das Verfüllmaterial ein Schmelzklebstoff sein, der auch als "Hot Melt" bezeichnet wird. Somit resultiert ein Aushärten alleine schon durch das Auskühlen, was auch noch gezielt durch einen Luftstrom oder dergleichen beschleunigt werden kann.

Auch kann das Verfüllmaterial eine UV-härtbar und/oder elektronenstrahlhärtbare und/oder thermisch härtbare Tinte sein, so dass der Aushärtungsvorgang gezielt gesteuert werden kann.

Erfindungsgemäß kann das Verfüllmaterial lösemittelfrei sein oder zumindest ein Lösemittel enthalten.

Auch kann das Verfüllmaterial partikelfrei sein oder mit Partikeln gefüllt sein. Dabei können zumindest einige Partikel, vorzugsweise sämtliche Partikel, im nano-skaligen Größenbereich liegen. Auch können zumindest einige Partikel, vorzugsweise sämtliche Partikel thermisch leitfähig sein.

Weiterhin können zumindest einige Partikel, vorzugsweise sämtliche Partikel, elektrisch leitfähig oder dielektrisch sein. Somit kann die Füllung der Öffnung beispielsweise bei einer Leiterplatte entweder als Durchkontaktierung dienen oder aber es kann eine elektrische Verbindung der Ebenen der Leiterplatte durch die Füllung der Öffnung vermieden werden.

Auch können zumindest einige Partikel, vorzugsweise sämtliche Partikel magnetisch sein.

Erfindungsgemäß können die beiden Ausgabeköpfe so ausgerichtet sein, dass die Flugbahn des von ihnen ausgegebenen Verfüllmaterials jeweils vertikal ausgerichtet oder aber nur leicht aus der Senkrechten ausgelenkt ist bzw. jeweils horizontal ausgerichtet oder aber nur leicht aus der Horizontalen ausgelenkt ist.

Für ein komplettes Verfüllen können sich die Tropfen idealerweise in der Mitte der Querschnittsfläche der Öffnung treffen und zerstäuben dann seitwärts und benetzen die Wandung der Öffnung. Wenn die Querschnittsfläche geschlossen ist, füllt sich die Öffnung dann von innen heraus weiter.

Bei einer horizontalen Ausrichtung sinken die Tropfen am Flug-Ende ab und fallen auf die Wandung der Öffnung. Es bildet sich dann zunächst eine Art "Mauer", bis die Querschnittsfläche dann geschlossen ist.

Wenn die Tropfen schräg in die Öffnung geschossen werden, benetzen sie die Wandung der Öffnung und füllen die Öffnung so von innen heraus.

Alternativ können die beiden Ausgabeköpfe so angesteuert werden und/oder ausgerichtet sein, dass sich die Tropfen nicht ideal überlappend treffen und somit die Öffnung von zwei Seiten aus verfüllen.

Die vorstehenden Varianten können gleichermaßen auch bei einem nicht vollständigen Füllen der Öffnung eingesetzt werden.

Bei einem bevorzugten Ausführungsbeispiel der Erfindung kann zumindest einer der beiden Ausgabeköpfe im Continous- und/oder Drop-on-Demand-Verfahren betrieben werden.

Bei dem Continuous-Inkjet-Verfahren wird das Verfüllmaterial beständig umgepumpt und der Verfüllmaterial-Strahl wird im Ausgabekopf mittels eines Schwingelementes in einzelne Tropfen aufgeteilt. Somit können bis zu 100.000 Tropfen pro Sekunde erzeugt werden. Von den erzeugten Tropfen können bis zu 30 % für das Verfüllen verwendet werden, indem diese Tropfen durch Polarisierung auf die entsprechende Oberfläche abgelenkt werden. Die anderen Tropfen werden aufgefangen und im Kreislauf dem System erneut zugeführt.

Durch dieses Verfahren ist ein sehr schnelles Auftragen möglich, und es können Tropfengrößen von 4 pl bis 2000 pl erzielt werden. Voraussetzung ist jedoch, dass das Verfüllmaterial entsprechend polarisierbar ist.

Demgegenüber wird beim Drop-on-Demand-Verfahren (DOD-Verfahren) das Verfüllmaterial nur dann freigegeben, wenn es benötigt wird.

Die Auftragsköpfe unterscheiden sich dabei nach folgenden Technologien: Ventiltechnik, Thermal Inkjet und Piezo Inkjet.

Bei der Thermo-Inkjet-Technik (TIJ) wird in einer Düse ein kleines, elektrisches Heizelement verwendet, durch welches das Verfüllmaterial, das sich in kleinen Kanälen im Auftragskopf befindet, bis zur Entstehung einer Gasblase erhitzt wird. Durch die Ausdehnung dieser Blase wird ein Tropfen des Verfüllmaterials aus der Düse geschleudert. Mittels dieses vergleichsweise langsamen Verfahrens können nur lösemittelhaltige oder wasserbasierende Verfüllmaterialien verarbeitet werden.

Hingegen werden bei Piezo-Inkjet-Systemen (PIJ) die Tropfen dadurch erzeugt, dass in einer Düse ein Piezoelement aus einem piezoelektrischen Keramikwerkstoff vorgesehen ist und hieran Spannung angelegt wird. Dadurch dehnt sich das Piezoelement aus und der Tropfen wird aus der Düse herausgedrückt. Mit dem Piezo-Inkjet-Verfahren kann die größte Bandbreite an einsetzbaren Verfüllmaterialien eingesetzt werden.

Die hier relevanten Auftragsköpfe können bis zu vier Reihen mit je 500 Düsen aufweisen. Dabei kann der Durchmesser dieser Düsen kleiner als der eines menschlichen Haares sein und jede einzelne Düse kann bis zu 100.000 Tintentropfen pro Sekunde ausstoßen, wobei sich der Tropfen dann mit einer Geschwindigkeit von bis zu 10 Metern pro Sekunde bewegt.

Im Folgenden werden in den Zeichnungen dargestellte Ausführungsbeispiele der Erfindung erläutert. Es zeigen:
- Fig. 1: ein erstes erfindungsgemäßes Verfahren,
- Fig. 2: ein zweites erfindungsgemäßes Verfahren und
- Fig. 3: ein drittes erfindungsgemäßes Verfahren.

In allen Figuren werden für gleiche bzw. gleichartige Bauteile übereinstimmende Bezugszeichen verwendet.

In den Figuren sind drei verschiedene Verfahren zum Verschließen einer kanalförmigen Öffnung 1 in einer Leiterplatte 6 mittels eines flüssigen aushärtenden Verfüllmaterials illustriert.

Dabei erfolgt das Verschließen der Öffnung 1 jeweils mittels eines digital gesteuerten Applikationsverfahrens mit zwei gegenüberliegend angeordneten Ausgabeköpfen 2, 3, wobei ein Inkjet-Verfahren Anwendung findet und die Ausgabeköpfe als gegenüberliegend angeordnete Druckköpfe ausgebildet sind.

Dabei werden die Ausgabeköpfe 2, 3 so angesteuert, dass die Öffnung 1 von beiden Seiten durch ihre beiden Enden gleichzeitig mit dem Verfüllmaterial verfüllt wird. Hierbei wird das Verfüllmaterial von den beiden Ausgabeköpfen 2, 3 unter Berücksichtigung der jeweiligen Leistungsdaten der beiden Ausgabeköpfe 2, 3 und des jeweiligen Abstands der beiden Ausgabeköpfe 2, 3 zu der Öffnung so ausgegeben, dass sich die ausgegebenen Mengen des Verfüllmaterials innerhalb der Öffnung treffen.

Damit fliegt das von den Ausgabeköpfen 2, 3 in die Öffnung injizierte Verfüllmaterials nicht durch die Öffnung 1 hindurch, sondern trifft auf das jeweils aus der anderen Richtung kommende Verfüllmaterial, wodurch das Verfüllmaterial zur Seite weg spritzt und sich an der Wandung der Öffnung anlagert.

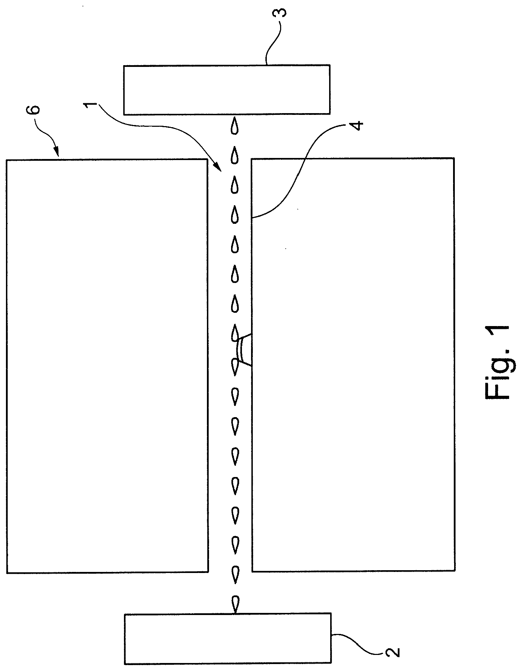

Bei dem in Fig. 1 gezeigten Verfahren werden die beiden Ausgabeköpfe 2, 3 so angesteuert, dass das Verfüllmaterial von den beiden Ausgabeköpfen 2, 3 unter Berücksichtigung der jeweiligen Leistungsdaten der beiden Ausgabeköpfe und des jeweiligen Abstands der beiden Ausgabeköpfe 2, 3 zu der Öffnung 1 so ausgegeben wird, dass sich die ausgegebenen Mengen des Verfüllmaterials im Bereich der Mitte der Durchgangslänge der Öffnung 1 nahe einer Wandung 4 der Öffnung 1 treffen. Unter Berücksichtigung der Gravitation kann dies vorzugsweise - wie gezeigt - die untere Wandung 4 der Öffnung 1 sein.

Dann bildet sich zuerst eine Ansammlung von Verfüllmaterial, die an einem Bereich der Wandung 4 der Öffnung 1 anliegt und dann an Höhe gewinnt, bis die Öffnung 1 in diesem Bereich durch eine Art Trennwandung 5 verschlossen ist. Dies ist vor allem bei einer kompletten Auffüllung von Vorteil, da sich dann zuerst eine in der Mitte der Durchgangslänge der Öffnung 1 angeordnete Trennwandung 5 bildet und die beiden dadurch resultierenden Sacklöcher dann jeweils durch den zugeordneten Ausgabekopf 2 bzw. 3 weiter gefüllt werden können.

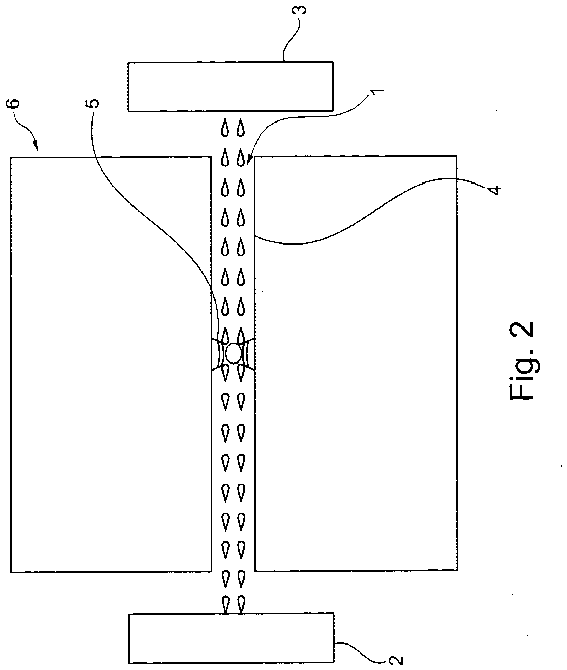

Alternativ kann auch, wie in Fig. 2 gezeigt, durch Ausgabeköpfe 2, 3 mit mehreren Düsen eine solche Trennwandung 5 quasi in einem Schritt erzielt werden. Auch das weitere Verfüllen gestaltet sich dann natürlich weniger zeitintensiv.

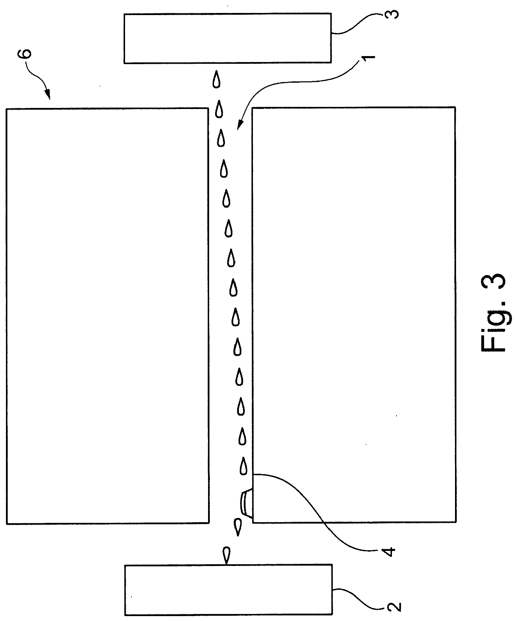

Darüber hinaus kann die Ausgabe des Verfüllmaterials durch die Ausgabeköpfe 2, 3 auch wie in Fig. 3 gezeigt erfolgen, wobei sich die ausgegebenen Mengen des Verfüllmaterials in etwa im Bereich eines Endes der Öffnung 1 treffen. Somit kann die Öffnung 1 einseitig bündig geschlossen werden, wohingegen sie von der anderen Seite aus auf und ungefüllt verbleibt.

## Patentansprüche

1. Verfahren zum zumindest teilweisen Verschließen einer kanalförmigen Öffnung (1) mit einer Querschnittsfläche und einer Durchgangslänge und zwei gegenüberliegenden Enden, insbesondere Durchgangs-Bohrungen oder Durchkontaktierungen in Leiterplatten (6), mit einem flüssigen härtbaren bzw. aushärtenden Verfüllmaterial, **dadurch gekennzeichnet, dass** das Verschließen der Öffnung (1) mittels eines digital gesteuerten Applikationsverfahrens mit zwei gegenüberliegend angeordneten Ausgabeköpfen (2, 3) erfolgt, vorzugsweise mit einem Inkjet-Verfahren mit zwei gegenüberliegend angeordneten, als Druckköpfe ausgebildeten Ausgabeköpfen (2, 3) erfolgt, wobei die beiden Ausgabeköpfe (2, 3) so angesteuert werden, dass die Öffnung (1) von beiden Seiten durch die beiden Enden gleichzeitig mit dem Verfüllmaterial verfüllt wird und das Verfüllmaterial von den beiden Ausgabeköpfen (2, 3) unter Berücksichtigung der jeweiligen Leistungsdaten der beiden Ausgabeköpfe (2, 3) und des jeweiligen Abstands der beiden Ausgabeköpfe (2, 3) zu der Öffnung (1) so ausgegeben wird, dass sich die ausgegebenen Mengen des Verfüllmaterials innerhalb der Öffnung (1) treffen, wobei die Querschnittsfläche der Öffnung in keiner Richtung eine Erstreckung hat, die größer ist als 3 mm bis 5 mm und kreisrund sein kann, so dass das von den Ausgabeköpfen in die Öffnung injizierte Verfüllmaterial nicht durch die Öffnung durch fliegt, sondern auf das aus der anderen Richtung kommende Verfüllmaterial trifft, wodurch dann das Verfüllmaterial zur Seite weg spritzt und sich an der Wandung der Öffnung anlagert, und wobei das Verfüllmaterial dabei mit einer Geschwindigkeit von 5 m/s bis 10 m/s aus den Ausgabeköpfen ausgegeben wird, was intermittierend erfolgt, so dass Tropfen ausgegeben werden, wobei weiterhin das Volumen der Tropfen 1 pl (Picoliter) bis 20 pl, vorzugsweise 3 pl bis 10 pl beträgt.

2. Verfahren nach dem vorhergehenden Anspruch, **dadurch gekennzeichnet, dass** die beiden Ausgabeköpfe (2, 3) so angesteuert werden, dass das Verfüllmaterial von den beiden Ausgabeköpfen (2, 3) unter Berücksichtigung der jeweiligen Leistungsdaten der beiden Ausgabeköpfe (2, 3) und des jeweiligen Abstands der beiden Ausgabeköpfe (2, 3) zu der Öffnung (1) so ausgegeben wird, dass sich die ausgegebenen Mengen des Verfüllmaterials zumindest in etwa im Bereich der Mitte der Durchgangslänge der Öffnung (1) treffen.

3. Verfahren nach einem der vorhergehenden Ansprüche, **dadurch gekennzeichnet, dass** die beiden Ausgabeköpfe (2, 3) so angesteuert werden, dass das Verfüllmaterial von den beiden Ausgabeköpfen (2, 3) unter Berücksichtigung der jeweiligen Leistungsdaten der beiden Ausgabeköpfe (2, 3) und des jeweiligen Abstands der beiden Ausgabeköpfe (2, 3) zu der Öffnung (1) so ausgegeben wird, dass sich die ausgegebenen Mengen des Verfüllmaterials zumindest in etwa im Bereich der Mitte der Querschnittsfläche der Öffnung (1) treffen.

4. Verfahren nach einem der vorhergehenden Ansprüche, **dadurch gekennzeichnet, dass** die beiden Ausgabeköpfe (2, 3) so angesteuert werden, dass das Verfüllmaterial von den beiden Ausgabeköpfen (2, 3) unter Berücksichtigung der jeweiligen Leistungsdaten der beiden Ausgabeköpfe (2, 3) und des jeweiligen Abstands der beiden Ausgabeköpfe (2, 3) zu der Öffnung so ausgegeben wird, dass die Querschnittsfläche der Öffnung (1) vollständig verschlossen wird.

5. Verfahren nach einem der vorhergehenden Ansprüche, **dadurch gekennzeichnet, dass** die beiden Ausgabeköpfe (2, 3) so angesteuert werden, dass das Verfüllmaterial von den beiden Ausgabeköpfen (2, 3) unter Berücksichtigung der jeweiligen Leistungsdaten der beiden Ausgabeköpfe (2, 3) und des jeweiligen Abstands der beiden Ausgabeköpfe (2, 3) zu der Öffnung (1) so ausgegeben wird, dass die Öffnung (1) vollständig verschlossen wird.

6. Verfahren nach einem der vorhergehenden Ansprüche, **dadurch gekennzeichnet, dass** das Verfüllmaterial ein Schmelzklebstoff ist.

7. Verfahren nach einem der vorhergehenden Ansprüche, **dadurch gekennzeichnet, dass** das Verfüllmaterial eine UV-härtbar und/oder elektronenstrahl-härtbare und/oder thermisch härtbare Tinte ist.

8. Verfahren nach einem der vorhergehenden Ansprüche, **dadurch gekennzeichnet, dass** das Verfüllmaterial lösemittelfrei ist oder zumindest ein Lösemittel enthält.

9. Verfahren nach einem der vorhergehenden Ansprüche, **dadurch gekennzeichnet, dass** das Verfüllmaterial partikelfrei ist oder mit Partikeln gefüllt ist.

10. Verfahren nach dem vorhergehenden Anspruch, **dadurch gekennzeichnet, dass** zumindest einige Partikel, vorzugsweise sämtliche Partikel, im nano-skaligen Größenbereich liegen.

11. Verfahren nach Anspruch 9 oder 10, **dadurch gekennzeichnet, dass** zumindest einige Partikel, vorzugsweise sämtliche Partikel thermisch leitfähig sind.

12. Verfahren nach einem der Ansprüche 9 bis 11, **dadurch gekennzeichnet, dass** zumindest einige Partikel, vorzugsweise sämtliche Partikel elektrisch leitfähig oder dielektrisch sind.

13. Verfahren nach einem der Ansprüche 9 bis 12, **dadurch gekennzeichnet, dass** zumindest einige Partikel, vorzugsweise sämtliche Partikel magnetisch sind.

14. Verfahren nach einem der vorhergehenden Ansprüche, **dadurch gekennzeichnet, dass** die beiden Ausgabeköpfe (2, 3) so ausgerichtet sind, dass die Flugbahn des von ihnen ausgegebenen Verfüllmaterials jeweils vertikal ausgerichtet oder aber nur leicht aus der Senkrechten ausgelenkt ist bzw. jeweils horizontal ausgerichtet oder aber nur leicht aus der Horizontalen ausgelenkt ist.

15. Verfahren nach einem der vorhergehenden Ansprüche, **dadurch gekennzeichnet, dass** zumindest einer der beiden Ausgabeköpfe im Continousund/oder Drop-on-Demand-Verfahren betrieben wird.

## Claims

1. Method for at least partially closing a channel-shaped opening (1), with a cross-section surface and a passage length and two opposing ends, in particular passage holes or passage contacts in printed circuit boards (6), with a fluid filling material which can be hardened or cured, **characterised in that** the closing of the opening (1) takes place by means of a digitally controlled application method with two opposing arranged outlet heads (2, 3), preferably with an ink-jet method with two opposing arranged outlet heads (2, 3) configured as printing heads, wherein the two outlet heads (2, 3) are actuated in a controlled manner in such a way that the opening (1) is filled with the filling material through both the ends simultaneously, and the filling material is emitted from the two outlet heads (2, 3) by taking account of the respective performance data of the two outlet heads (2, 3) and the respective distance interval between the two outlet heads (2, 3) and the opening (1), in such a way that the quantities of the filling material emitted meet inside the opening (1), wherein the cross-section surface of the opening does not have an extension in any direction which is greater than 3 mm to 5 mm, and can be circular, such that the filling material injected into the opening by the outlet heads does not flow through the opening but meets the filing material coming from the other direction, as a result of which the filling material then jets away to the side and is deposited on the wall of the opening, and wherein the filling material is emitted in this situation at a speed of 5 m/s to 10 m/s from the outlet heads, which takes place intermittently in such a way that drops are emitted, wherein the volume of the drops continued to amount to 1 pl (Picolitre) to 20 pl, preferably 3 pl to 10 pl.

2. Method according to the preceding claim, **characterised in that** the two outlet heads (2, 3) are actuated in a controlled manner in such a way that the filling material is emitted from the two outlet heads (2, 3) by taking account of the respective performance data of the two outlet heads (2, 3) and the respective distance interval between the two outlet heads (2, 3) and the opening (1), in such a way that the quantities of the filling material emitted meet at least approximately in the region of the middle of the passage length of the opening (1).

3. Method according to any one of the preceding claims, **characterised in that** the two outlet heads (2, 3) are actuated in a controlled manner in such a way that the filling material is emitted from the two outlet heads (2, 3) by taking account of the respective performance data of the two outlet heads (2, 3) and the respective distance interval between the two outlet heads (2, 3) and the opening (1), in such a way that the quantities of the filling material emitted meet at least approximately in the region of the middle of the cross-section surface of the opening (1).

4. Method according to any one of the preceding claims, **characterised in that** the two outlet heads (2, 3) are actuated in a controlled manner in such a way that the filling material is emitted from the two outlet heads (2, 3) by taking account of the respective performance data of the two outlet heads (2, 3) and the respective distance interval between the two outlet heads (2, 3) and the opening, in such a way that the cross-section surface of the opening (1) is entirely closed.

5. Method according to any one of the preceding claims, **characterised in that** the two outlet heads (2, 3) are actuated in a controlled manner in such a way that the filling material is emitted from the two outlet heads (2, 3) by taking account of the respective performance data of the two outlet heads (2, 3) and the respective distance interval between the two outlet heads (2, 3) and the opening (1), in such a way that the opening (1) is entirely closed.

6. Method according to any one of the preceding claims, **characterised in that** the filling material is a melt adhesive.

7. Method according to any one of the preceding claims, **characterised in that** the filling material is a UV-hardening and/or electron beam-hardening and/or thermally-hardening ink.

8. Method according to any one of the preceding claims, **characterised in that** the filling material is free of solvents or contains at least one solvent.

9. Method according to any one of the preceding claims, **characterised in that** the filling material is free of particles or is filled with particles.

10. Method according to the preceding claim, **characterised in that** at least some particles, and preferably all the particles, lie in the nanoscale size range.

11. Method according to claim 9 or 10, **characterised in that** at least some particles, and preferably all the particles, are thermally conductive.

12. Method according to any one of claims 9 to 11, **characterised in that** at least some particles, and preferably all the particles, are electrically conductive or dielectric.

13. Method according to any one of claims 9 to 12, **characterised in that** at least some particles, and preferably all the particles, are magnetic.

14. Method according to any one of the preceding claims, **characterised in that** the two outlet heads (2, 3) are aligned in such a way that the trajectory of the filling material emitted by them is in each case aligned vertically or deflects only slightly out of the vertical, or is in each case aligned horizontally or deflects only slightly out of the horizontal.

15. Method according to any one of the preceding claims, **characterised in that** at least one of the two outlet heads is operated with the continuous method and/or drop-on-demand method.

## Revendications

1. Procédé d'obturation au moins partielle, à l'aide d'un matériau de comblement fluide, respectivement durcissable ou à durcissement intégral, d'une ouverture (1) en forme de canal présentant une aire de section transversale, une longueur de passage et deux extrémités opposées, en particulier des perçages traversants ou des trous d'interconnexion pratiqués dans des plaquettes (6) à circuits imprimés, **caractérisé par le fait que** l'obturation de l'ouverture (1) s'opère au moyen d'un procédé d'application à commande numérique, à l'aide de deux têtes de distribution (2, 3) placées en vis-à-vis l'une de l'autre, de préférence par un procédé à jets d'encre, à l'aide de deux têtes de distribution (2, 3) placées en vis-à-vis l'une de l'autre et réalisées sous la forme de têtes d'impression, lesquelles deux têtes de distribution (2, 3) sont pilotées de façon telle que l'ouverture (1) soit simultanément comblée des deux côtés par le matériau de comblement, à travers les deux extrémités, et que ledit matériau de comblement soit dispensé par les deux têtes de distribution (2, 3), avec prise en compte des données de performance respectives desdites deux têtes de distribution (2, 3) et de la distance respectivement comprise entre l'ouverture (1) et lesdites deux têtes de distribution (2, 3), de manière que les quantités dispensées dudit matériau de comblement se rencontrent à l'intérieur de l'ouverture (1), sachant que l'aire de section transversale de ladite ouverture ne présente, dans aucune direction, une étendue excédant de 3 mm à 5 mm et peut être de forme circulaire, de telle sorte que le matériau de comblement injecté dans l'ouverture par les têtes de distribution ne parcoure pas ladite ouverture de bout en bout, mais vienne rencontrer le matériau de comblement provenant de l'autre direction, si bien que ledit matériau de comblement est ensuite projeté de côté et se dépose sur la paroi de ladite ouverture, et sachant que ledit matériau de comblement est alors dispensé à une vitesse de 5 m/s à 10 m/s à partir des têtes de distribution, ce qui a lieu par intermittence, impliquant ainsi la délivrance de gouttes, sachant par ailleurs que le volume desdites gouttes mesure de 1 pl (picolitre) à 20 pl, préférentiellement de 3 pl à 10 pl.

2. Procédé selon la revendication précédente, **caractérisé par le fait que** les deux têtes de distribution (2, 3) sont pilotées de façon telle que le matériau de comblement soit dispensé par les deux têtes de distribution (2, 3), avec prise en compte des données de performance respectives desdites deux têtes de distribution (2, 3) et de la distance respectivement comprise entre l'ouverture (1) et lesdites deux têtes de distribution (2, 3), de manière que les quantités dispensées dudit matériau de comblement se rencontrent, au moins approximativement, dans la région du milieu de la longueur de passage de ladite ouverture (1).

3. Procédé selon l'une des revendications précédentes, **caractérisé par le fait que** les deux têtes de distribution (2, 3) sont pilotées de façon telle que le matériau de comblement soit dispensé par les deux têtes de distribution (2, 3), avec prise en compte des données de performance respectives desdites deux têtes de distribution (2, 3) et de la distance respectivement comprise entre l'ouverture (1) et lesdites deux têtes de distribution (2, 3), de manière que les quantités dispensées dudit matériau de comblement se rencontrent, au moins approximativement, dans la région du centre de l'aire de section transversale de ladite ouverture (1).

4. Procédé selon l'une des revendications précédentes, **caractérisé par le fait que** les deux têtes de distribution (2, 3) sont pilotées de façon telle que le matériau de comblement soit dispensé par les deux têtes de distribution (2, 3), avec prise en compte des données de performance respectives desdites deux têtes de distribution (2, 3) et de la distance respectivement comprise entre l'ouverture et lesdites deux têtes de distribution (2, 3), de manière que l'aire de section transversale de ladite ouverture (1) soit obturée en totalité.

5. Procédé selon l'une des revendications précédentes, **caractérisé par le fait que** les deux têtes de distribution (2, 3) sont pilotées de façon telle que le matériau de comblement soit dispensé par les deux têtes de distribution (2, 3), avec prise en compte des données de performance respectives desdites deux têtes de distribution (2, 3) et de la distance respectivement comprise entre l'ouverture (1) et lesdites deux têtes de distribution (2, 3), de manière que ladite ouverture (1) soit obturée en totalité.

6. Procédé selon l'une des revendications précédentes, **caractérisé par le fait que** le matériau de comblement est un adhésif thermofusible.

7. Procédé selon l'une des revendications précédentes, **caractérisé par le fait que** le matériau de comblement est une encre durcissable aux UV et/ou une encre durcissable par faisceaux d'électrons, et/ou thermodurcissable.

8. Procédé selon l'une des revendications précédentes, **caractérisé par le fait que** le matériau de comblement est exempt de solvant, ou renferme au moins un solvant.

9. Procédé selon l'une des revendications précédentes, **caractérisé par le fait que** le matériau de comblement est exempt de particules, ou est empli de particules.

10. Procédé selon la revendication précédente, **caractérisé par le fait qu'**au moins quelques particules, de préférence toutes les particules, se situent dans la plage de tailles à échelle nanométrique.

11. Procédé selon la revendication 9 ou 10, **caractérisé par le fait qu'**au moins quelques particules, de préférence toutes les particules, sont douées de conductivité thermique.

12. Procédé selon l'une des revendications 9 à 11, **caractérisé par le fait qu'**au moins quelques particules, de préférence toutes les particules, sont douées de conductivité électrique ou sont diélectriques.

13. Procédé selon l'une des revendications 9 à 12, **caractérisé par le fait qu'**au moins quelques particules, de préférence toutes les particules, sont magnétiques.

14. Procédé selon l'une des revendications précédentes, **caractérisé par le fait que** les deux têtes de distribution (2, 3) sont orientées de façon telle que la trajectoire du matériau de comblement qu'elles dispensent soit dirigée à chaque fois dans le sens vertical, voire n'accuse qu'une faible déviation par rapport à la verticale, ou soit respectivement dirigée dans le sens horizontal, voire n'accuse qu'une faible déviation par rapport à l'horizontale.

15. Procédé selon l'une des revendications précédentes, **caractérisé par le fait qu'**au moins l'une des deux têtes de distribution est exploitée suivant le procédé à flux continu et/ou en goutte à goutte à la demande.
